# FASCICULE DE BREVET EUROPEEN

(11) **EP 3 804 116 B1**
(45) Date de publication et mention de la délivrance du brevet: **13.07.2022**
(21) Numéro de dépôt: 19730206.0
(22) Date de dépôt: 15.05.2019
(51) Int. Cl.: H02N 2/18

(54) **RECUPERATEUR D'ENERGIE VIBRATOIRE**
VIBRATIONSENERGIEUMWANDLER
VIBRATION ENERGY HARVESTER

(30) Priorité: 29.05.2018 FR 1870614
(43) Date de publication de la demande: 14.04.2021
(73) Titulaire: Université Savoie Mont Blanc, 73011 Chambéry Cedex (FR)
(72) Inventeur: BADEL, Adrien, 73340 LESCHERAINES (FR); FORMOSA, Fabien, 74940 ANNECY-LE-VIEUX (FR)
(74) Mandataire: Talbot, Alexandre
(86) Numéro de dépôt international: PCT/FR2019/051110
(87) Numéro de publication internationale: WO 2019/229318

(56) Documents cités:
- WO-A1-02/29965
- WO-A1-2006/046938
- WO-A1-2011/073591
- CN-B- 101 854 130
- JP-A- 2014 121 168
- US-A1- 2012 119 620

## Description

### Domaine

La présente description concerne de façon générale les récupérateurs d'énergie et, plus particulièrement, les dispositifs de récupération d'énergie vibratoire, adaptés à produire de l'électricité à partir de vibrations mécaniques. La présente description s'applique notamment à la production d'électricité par des équipements susceptibles de vibrer, par exemple des gaines de climatisation d'un bâtiment, des ordinateurs en fonctionnement, des machines industrielles, des moteurs, des véhicules, des infrastructures de transport, etc.

### État de l'art antérieur

On sait depuis longtemps qu'il est possible de récupérer de l'électricité à partir de vibrations d'un système mécanique. Certains convertisseurs mécano-électriques ou récupérateurs vibratoires utilisent des éléments piézoélectriques pour convertir une énergie mécanique provenant des vibrations en électricité.

Un exemple de générateur électrique à récupération d'énergie de vibrations mécaniques est décrit dans le document WO-A-2011/073591 (B9966PCT). Dans la solution décrite dans ce document, on assiste à un mouvement d'une masse (27) entre deux positions, qui est initié par un déplacement des deux points d'extrémité de la lame flexible (25). Le niveau de flambement varie selon les positions du système.

Le document WO-A-2006/046938 décrit un dispositif piézoélectrique basé sur une récupération d'énergie vibratoire, dans lequel une lame flexible est placée dans différentes configurations de flambement par déplacement de ses extrémités.

Le document JP-A-2014-121168 décrit une solution dans laquelle un élément rotatif provoque par contact et pression mécanique une déformation d'une lame.

Le document CN-A-101854130 décrit un convertisseur d'énergie mécano-électrique.

Le document US-A-2012/0119620 décrit un appareil et un procédé d'amplification de force multiétages d'empilements piézoélectriques.

Le document WO-A-2002/029965 décrit un collecteur d'énergie piézoélectrique.

### Résumé

Il existe un besoin d'amélioration des convertisseurs mécano-électriques en termes d'industrialisation.

Il existe également un besoin d'amélioration des générateurs électriques à récupération d'énergie de vibrations mécaniques en termes de fiabilité.

Un mode de réalisation pallie tout ou partie des inconvénients des récupérateurs d'énergie vibratoire usuels.

Un mode de réalisation prévoit un dispositif de récupération d'énergie mécanique vibratoire comportant un ensemble de lames ressort entre deux points fixes, et au moins deux masses respectivement de part et d'autre de l'ensemble de lames, dans lequel l'ensemble de lames est mis en flambage entre les deux points par rapprochement des masses l'une vers l'autre, l'ensemble de lames ayant, une fois mis en flambage, exactement deux positions stables.

Selon un mode de réalisation, sans action mécanique extérieure, les deux positions stables de l'ensemble de lames sont symétriques par rapport à une droite reliant les deux points fixes.

Selon un mode de réalisation, lesdites masses sont distinctes de lames dudit ensemble de lames.

Selon un mode de réalisation, l'écart entre les deux masses est, une fois l'ensemble de lames mis en flambage, maintenu constant indépendamment de l'énergie mécanique vibratoire appliquée au dispositif.

Selon un mode de réalisation, lesdites deux positions sont stables en l'absence de sollicitation extérieure.

Selon un mode de réalisation, la récupération d'énergie est due au passage de l'ensemble de lames, sous l'effet de l'énergie mécanique vibratoire, d'une desdites deux positions à l'autre.

Selon un mode de réalisation, l'ensemble de lames comporte une portion centrale entre deux bras d'extrémité, la portion centrale comportant deux bras centraux respectivement associés aux deux masses.

Selon un mode de réalisation, chaque bras central est fixé, en son milieu, à la masse à laquelle il est associé.

Selon un mode de réalisation, chaque masse comporte une plaque dont un bord est fixé, par une partie en saillie, à un des bras centraux.

Selon un mode de réalisation, le dispositif comporte au moins un dispositif de conversion mécano-électrique entre une extrémité de l'ensemble de lames et l'un desdits points.

Selon un mode de réalisation, le dispositif comporte au moins un dispositif de conversion mécano-électrique à chaque extrémité de l'ensemble de lames.

Selon un mode de réalisation, chaque dispositif de conversion comporte un élément piézoélectrique dans une direction approximativement perpendiculaire à la direction de l'ensemble de lames.

Selon un mode de réalisation, chaque dispositif de conversion comporte une armature en forme de double arceau, les milieux des arceaux étant reliés respectivement à une extrémité de l'ensemble de lames et à l'un des points.

Selon un mode de réalisation, lesdits points font partie de deux bords opposés d'un cadre à l'intérieur duquel sont logés l'ensemble de lames et les masses.

Un mode de réalisation prévoit un système de production d'électricité comportant un équipement soumis à des vibrations mécaniques et un dispositif de récupération d'énergie mécanique vibratoire.

Selon un mode de réalisation, le dispositif est fixé à l'équipement.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue très schématique illustrant le principe de fonctionnement d'un générateur électrique de récupération d'énergie mécanique de vibration, de type bistable ;
la figure 2 est une vue en plan très schématique d'un mode de réalisation d'un dispositif de récupération d'énergie vibratoire et de conversion en énergie électrique en situation monostable ;
la figure 3 est une vue en plan très schématique du dispositif de la figure 2, en situation bistable ;
la figure 4 est une vue partielle en perspective d'un ensemble de lames ressort du dispositif des figures 2 et 3 ;
la figure 5 représente, de façon très schématique, une vue agrandie et partielle d'un autre mode de réalisation d'un ensemble de lames d'un dispositif de récupération d'énergie ; et
la figure 6 illustre, de façon schématique, un mode de réalisation d'un convertisseur mécano-électrique adapté aux modes de réalisation de récupérateurs d'énergie décrits.

### Description détaillée

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, le système, équipement, dispositif ou environnement, fournissant l'énergie vibratoire (les vibrations) n'a pas été détaillé, les modes de réalisation décrits étant compatibles avec les sources usuelles de vibrations dans des applications de conversion en énergie électrique. De plus, l'utilisation faite de l'énergie électrique récupérée n'a pas non plus été détaillée, les modes de réalisation décrits étant, là encore, compatibles avec les applications usuelles des récupérateurs d'énergie et de conversion en électricité.

Sauf précision contraire, lorsque l'on fait référence à deux éléments connectés ou fixés entre eux, cela signifie directement reliés sans éléments intermédiaires autre qu'un liant de type colle, soudure ou vissage, et lorsque l'on fait référence à deux éléments associés ou couplés entre eux, cela signifie que ces deux éléments peuvent être directement reliés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

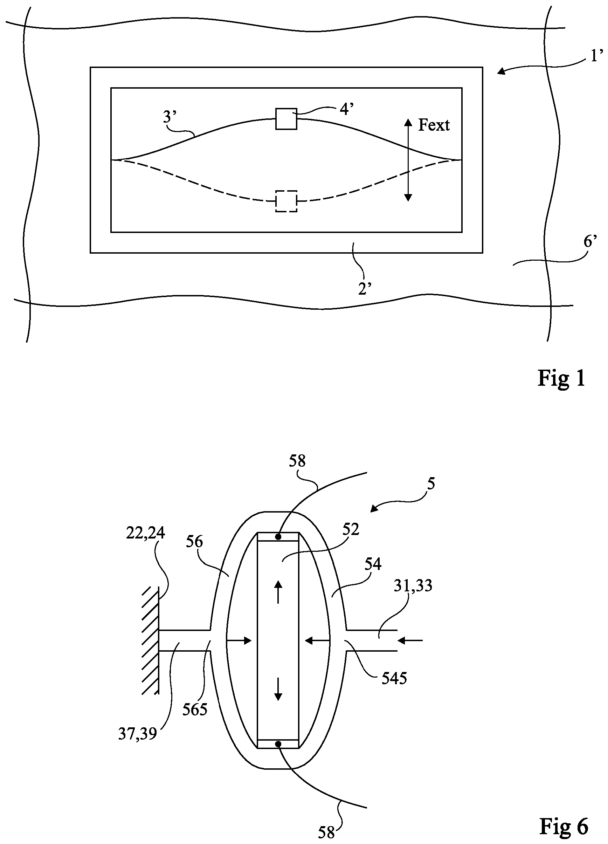

La figure 1 est une vue très schématique illustrant le principe de fonctionnement d'un générateur électrique 1' de récupération d'énergie mécanique de vibration, de type bistable.

Le générateur 1' comprend un boîtier de support et de protection 2', de forme générale parallélépipédique, adapté à être monté sur une surface vibrante 6'. Dans cet exemple, les vibrations extérieures sont susceptibles d'exercer, sur le boîtier 2', une excitation dont l'effet peut être représenté schématiquement par une force d'orientation Fext. Le boîtier 2' contient une lame ressort 3' dont les deux extrémités s'appuient, en compression, sur deux faces latérales opposées du boîtier. Les deux points d'appui de la lame 3' sur le boîtier 2' sont placés selon un axe sensiblement orthogonal à l'orientation Fext des vibrations. En d'autres termes, l'énergie mécanique vibratoire récupérée par le dispositif est liée à la composante de la force Fext orthogonale à une droite (fictive) reliant les deux points d'appui de la lame 3' sur le boîtier. Une masse 4' est fixée à la lame 3', sensiblement en son milieu. La lame 3', en compression entre ses deux extrémités, et la masse 4', définissent un système non linéaire, ou bistable, qui peut, sous l'effet des vibrations extérieures, passer de l'une à l'autre de deux positions d'équilibre stable (représentées respectivement en trait plein et en traits pointillés sur la figure). Ce système peut également osciller autour de chacune des deux positions d'équilibre ou positions stables. Un convertisseur mécano-électrique (non représenté), de type piézoélectrique, est prévu pour convertir le mouvement de la lame 3' et de la masse 4', en énergie électrique.

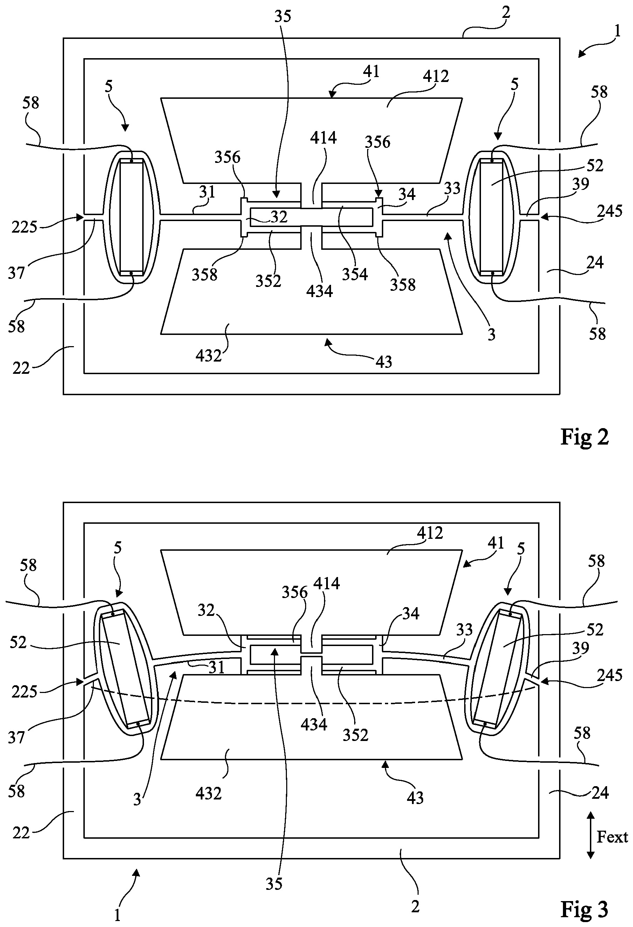

La figure 2 est une vue en plan très schématique d'un mode de réalisation d'un dispositif 1 de récupération d'énergie vibratoire et de conversion en énergie électrique en situation monostable, avant mise en service.

La figure 3 est une vue en plan très schématique du dispositif 1 de la figure 2, en situation bistable, pour mise en service.

Pour simplifier la description des figures 2 et 3, on ne se préoccupe pas de l'équipement fournissant les vibrations du système dans lequel est inclus le dispositif de récupération d'énergie.

Selon les modes de réalisation décrits, le dispositif 1 de récupération d'énergie comporte un boîtier support pourvu d'un cadre rigide 2. Le boîtier est par exemple refermé par deux plaques (non représentées), de part et d'autre du cadre 2, afin de protéger l'intérieur de la poussière ou autre.

Un ensemble 3 de lames ressort constitue le mécanisme de récupération de l'énergie vibratoire. L'ensemble 3 est monté entre deux dispositifs 5 de conversion d'énergie. Chacun des dispositifs 5 s'appuie sur une de deux faces latérales 22 et 24 opposées du boîtier, directement ou par l'intermédiaire d'un élément de liaison. Les deux points d'appui 225 et 245 de la structure obtenue (ensemble 3 plus dispositifs 5) sur le cadre 2 sont placés selon un axe sensiblement orthogonal à l'orientation Fext attendue des vibrations. Les sollicitations externes au dispositif, ou vibrations, dont l'énergie est récupérée par celui-ci sont des sollicitations appliquées au cadre 2 ou au boîtier support.

Selon le mode de réalisation de la figure 2, les deux points 225 et 245 sont des points fixes, c'est-à-dire des points fixes par rapport au cadre 2 dans lequel est inclus l'ensemble 3 et les dispositifs 5.

Une particularité de ce système est qu'il peut être contraint, pour une mise en service, vers une situation d'élongation de façon à le basculer d'une situation monostable (rectiligne) à une situation bistable (flambée). Ainsi, l'ensemble de lames est destiné à être mis en flambage entre deux positions stables, c'est-à-dire, qu'une fois mis en flambage, l'ensemble de lames comporte deux et seulement deux positions stables en l'absence de sollicitations extérieures.

Plus précisément, l'ensemble de lames 3 comporte deux bras de lame d'extrémité 31 et 33, chacun relié à un dispositif de conversion d'énergie 5. Les bras 31 et 33, dont les extrémités distales sont reliées aux dispositifs 5, ont leurs extrémités proximales reliées, de préférence directement, à une portion centrale 35 de l'ensemble 3. Cette portion centrale 35 comporte deux bras centraux de lame 352 et 354, reliés (de préférence fixés directement) chacun à au moins une masse 41, 43. Les bras 352 et 354 sont, dans l'exemple des figures 2 et 3, approximativement parallèles entre eux. Les bras 352 et 354 sont, dans cet exemple, reliés aux bras 31 et 33, par des portions 32 et 34 de lames perpendiculaires aux bras 352 et 354. Dans l'exemple représenté, chaque bras 352, 354 est associé à une masse, respectivement 41, 43, en forme générale de plaque 412, 432. Les plaques 412 et 432 sont approximativement coplanaires, de préférence coplanaires, l'une avec l'autre. Elles s'inscrivent de préférence dans un plan, approximativement perpendiculaire, de préférence perpendiculaire, aux lames et à tous les côtés du cadre 2. Les masses 41 et 43 sont de préférence identiques afin de respecter la symétrie de l'ensemble. Les masses 41 et 43 sont distinctes des lames 31 et 33 en ce sens qu'il s'agit d'éléments ajoutés à ces lames et qui ajoutent une masse par rapport à la masse des lames elles-mêmes. La récupération d'énergie du dispositif décrit est liée au mouvement inertiel provoqué par la présence de masses additionnelles à l'ensemble de lames et qui permet d'obtenir un mouvement des masses en translation, dans le plan du dispositif, dans une direction orthogonale à l'axe du dispositif (droite fictive entre les deux points 225 et 245).

En position désactivée ou inactive (figure 2), avant mise en service ou issue de fabrication, les bras 352 et 354 de l'ensemble de lames 3 sont, dans l'exemple des figures 2 et 3, alignés ou parallèles entre eux. De même, les portions 32 et 34 sont rectilignes et parallèles entre eux. Ainsi, les masses 41 et 43 qui sont fixées aux bras 352 et 354 de la portion centrale 35 sont écartées l'une de l'autre. Dans cette position désactivée, ou position hors service, on peut considérer que le système possède une seule position stable qui est la position dans laquelle les lames ou bras 31 et 32 sont alignés entre les deux points 224 et 245.

Dans le mode de réalisation des figures 2 et 3, on suppose que les bras 352 et 354 sont plus épais que les portions 32 et 34.

L'activation du dispositif 1 s'effectue en contraignant les bras 352 et 354 de la portion centrale 35 l'un vers l'autre, donc les masses 41 et 43 l'une vers l'autre. Comme les portions 32 et 34 sont plus fines que les bras 352 et 354, les bras ne se déforment pas et restent parallèle l'un à l'autre. Cela a pour effet de déformer (d'allonger) les portions 32 et 34 vers l'extérieur (vers les dispositifs 5), donc d'allonger l'ensemble de lames 3, ce qui provoque un flambement (ou flambage) à l'intérieur du cadre 2 sans avoir à déformer le cadre. Ce flambement rend le système bistable avec deux positions stables de part et d'autre de la position médiane ou inactive (figure 2), définie par une droite reliant les deux points 225 et 245. Une fois les masses 41 et 43 contraintes l'une vers l'autre, donc la structure mise en flambement, la position médiane n'est plus une position stable.

L'activation du dispositif s'effectue de préférence une fois pour toute à la mise en service. L'activation ne correspond pas aux vibrations mécaniques dont l'énergie est destinée à être récupérée, mais une contrainte indépendante des sollicitations extérieures dont on souhaite récupérer l'énergie. Ces sollicitations ou vibrations provoquent, une fois le dispositif activé, le passage de l'ensemble de lames d'une des positions stables à l'autre ainsi que des oscillations autour de chaque position stable. Lors du passage d'une position stable à l'autre, l'ensemble de lames passe par la position médiane devenue, après activation, une position instable.

En d'autres termes, dans un dispositif à deux points fixes, le niveau de flambement de la structure n'est pas modifié par les sollicitations extérieures dont l'énergie est récupérée.

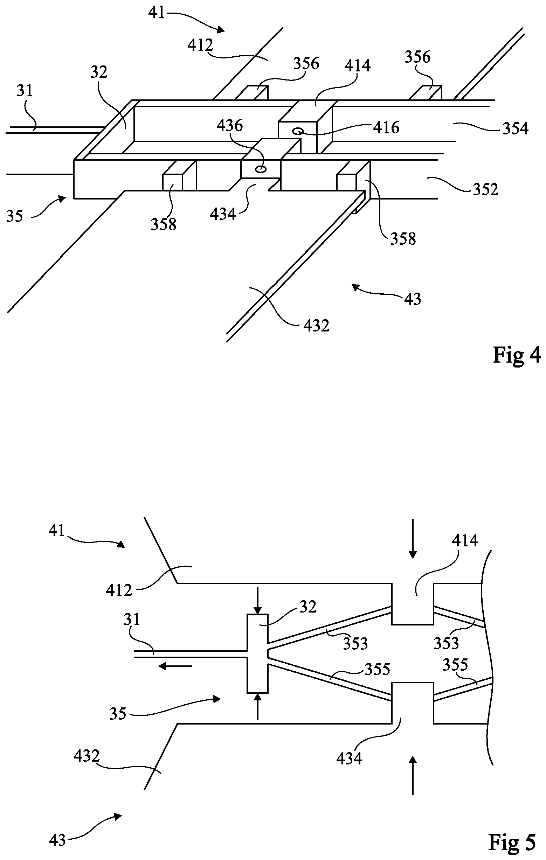

Selon une variante qui sera illustrée par la suite en relation avec la figure 5, les portions 32 et 34 sont plus épaisses que les bras 352 et 354. Un effet similaire d'allongement de l'ensemble de lames est alors obtenu par déformation des bras.

Ainsi, à la différence des systèmes usuels où le caractère bistable est obtenu en apportant une contrainte sur le cadre, les modes de réalisation décrits prévoient d'intervenir sur l'ensemble de lames à ressort lui-même.

Un avantage est que cela rend le système plus fiable dans une réalisation industrielle. En effet, un dispositif 1 peut être fixé à l'équipement vibrant du système sans se préoccuper d'un quelconque réglage du flambage réalisé, ce dernier étant réalisé à l'intérieur du cadre 2.

De plus, il est ainsi possible de concevoir, et même le cas échéant de monter, le dispositif 1 sur l'équipement auquel il est destiné sans contrainte, c'est-à-dire dans une situation monostable (figure 2), et de ne le mettre en service qu'ultérieurement en provoquant le rapprochement des bras centraux 352 et 354 de l'ensemble de lames à ressort 3.

La figure 4 est une vue partielle en perspective d'un ensemble de lames ressort du dispositif des figures 2 et 3.

Selon un mode de réalisation préféré, chaque masse 41, 43 comporte, en saillie du bord de la plaque 412, 432, proximal des bras 352 et 354, une patte 414, 434 perpendiculaire à ce bord et aux bras 352 et 354. Les pattes 414 et 434 se font face et sont destinées à venir bout à bout l'une contre l'autre en position active (figure 3). Elle constitue en quelques sorte une butée à la mise en flambage.

De préférence, la portion centrale 35 de l'ensemble de lames comporte, de part et d'autre des pattes 414 et 434, des portions 356 et 358 en saillie vers l'extérieur de l'ensemble, c'est-à-dire vers les plaques respectives 412 et 432. Le rôle de ces portions 356 et 358 est de constituer des butées portant, lorsque le système est en position de flambage, contre les bords (les tranches) des plaques 412 et 432 en regard, et ainsi d'éviter la rotation des masses 41 et 43, dans le plan des plaques 412 et 432 lors d'une sollicitation rectiligne.

Dans l'exemple illustré par la figure 4, les butées 356 et 358 sont situées entre les portions 32 et 34 et les pattes 414 et 434. Dans l'exemple des figures 2 et 3, les butées 356 et 358 sont constituées par les extrémités des portions 32 et 34 qui dépassent des bras 352 et 354.

Selon un exemple de réalisation, la mise en flambage s'effectue en vissant les pattes 414 et 434 l'une à l'autre (par exemple à travers des orifices 416 et 436 alignés pour rapprocher les masses 41 et 43 l'une vers l'autre). Les pattes 414 et 434 ne sont toutefois pas en contact en situation de flambage.

Dans l'exemple de la figure 4, on a illustré arbitrairement des plaques 41 et 43 plus fines que les bras 352 et 354. Toutefois, en pratique, ces plaques peuvent être de même épaisseur, voire plus épaisses que les bras 352 et 354. En effet, on recherche généralement à maximiser le poids des masses pour accroitre les effets du convertisseur.

La figure 5 représente, de façon très schématique, une vue agrandie et partielle d'un autre mode de réalisation de la portion centrale 35 d'un ensemble de lames 3 d'un dispositif de récupération d'énergie.

La figure 5 représente le système avant flambage, c'est-à-dire dans une position monostable centrale telle qu'illustrée par la figure 2.

Selon cet exemple, la portion centrale 35 comporte, de part et d'autre des pattes 414 et 434 des masses 41 et 43, des bras centraux 353, respectivement 355, reliant ces pattes à des portions 32 et 34 (seule la portion 32 est visible en figure 5) de liaison aux bras 31 et 33 (seul le bras 31 est visible en figure 5). Les bras 353 et 355 décrivent, en position inactive, un losange, c'est-à-dire que les extrémités de deux bras 31 et 33 en regard sont, côté pattes 414, respectivement 434, plus éloignées l'une de l'autre que côte portion 32, 34. Les bras 353 et 355 ne sont donc pas parallèles entre eux en position inactive. Selon ce mode de réalisation, les portions 32 et 34 sont plus épaisses que les bras 353 et 355. La mise en flambage de la structure (flèches en figure 5) s'effectue en rapprochant les pattes 414 et 434, donc les plaques 412 et 432, l'une vers l'autre, jusqu'à ce que les tranches des plaques viennent en butées contre les extrémités des portions 32 et 34, les pattes 414 et 434 restant avec un jeu entre elles. Cela provoque un allongement de l'ensemble de lames et, comme le cadre 2 est rigide, un flambage de l'ensemble de lames 3.

Chaque dispositif 5 de conversion d'énergie comporte un élément piézoélectrique 52 contraint, dans les modes de réalisation représentés, par une armature, généralement désignée flextenseur, ici en forme de double arceau 54, 56, ou de losange.

La figure 6 est une vue agrandie d'un mode de réalisation d'un dispositif 5 de conversion d'énergie adapté aux modes de réalisation de récupérateurs d'énergie décrits.

Le milieu des arceaux 54 et 56 est relié, pour l'un, à l'une 31 ou 33 des lames d'extrémité de l'ensemble de lames 3 et, pour l'autre, au bord respectivement 22, 24 du cadre 2, de préférence par l'intermédiaire d'un bras terminal 37, respectivement 39. Les extrémités des arceaux 54 et 56 sont fixées aux extrémités de l'élément piézoélectrique 52 (par exemple, un empilement de plaques piézoélectriques interdigitées, un barreau piézoélectrique ou tout autre structure piézoélectrique adaptée). Les liaisons 545 et 565 des milieux des arceaux 54 et 56 aux lames 31 et 37, respectivement 33 et 39, sont par exemple rigides (collage ou soudure), ou réalisées par l'intermédiaire de liaisons pivot. Les électrodes d'extrémité de l'élément piézoélectrique 52 sont reliées, par des fils conducteurs 58 traversant le cadre 2, à des circuits électriques/électroniques (non représentés) de mise en forme du signal électrique récupéré.

L'effet piézoélectrique est obtenu en déformant (écrasant, relâchant) les arceaux 54 et 56 depuis leurs parties médianes (liaisons 545 et 565), ce qui provoque une contrainte (extension, compression) de l'élément piézoélectrique 52 et génère de l'électricité. En figure 6, des flèches illustrent les contraintes lors du passage du système par la position médiane (instable). L'élément piézoélectrique 52 est contraint en extension sous l'effet d'un rapprochement des points 545 et 565 l'un vers l'autre qui provoque une élongation de l'armature.

On note que la direction active de l'élément piézoélectrique 52 est approximativement perpendiculaire à la direction de l'ensemble de lames 3, donc approximativement parallèle à la direction des vibrations.

On aurait pu penser intercaler, dans l'alignement d'une lame ressort, un élément piézoélectrique. Toutefois cela engendrerait des contraintes trop importantes en torsion sur celui-ci. Un avantage des dispositifs de conversion décrits est que l'élément piézoélectrique 52 est protégé, les arceaux 54 et 56 conférant une forme de cadre en losange non carré dans une diagonale duquel est fixé l'élément (par exemple le barreau) piézoélectrique 52.

La cinématique du dispositif 1 en fonctionnement est la suivante. Partant d'une des deux positions stables, par exemple celle illustrée en traits pleins en figure 3, un déplacement de l'ensemble de lames et des masses vers l'autre position stable (trait pointillé symbolisant la position de l'ensemble de lames) engendre un écrasement des arceaux 54 et 56 des dispositifs 5 de conversion pour passer la position médiane, d'où un allongement des éléments piézoélectriques 52, ce qui provoque la génération d'électricité. Le système se relâche en arrivant à l'autre position stable. Le cadre 2 est fixé rigidement, par exemple vissé ou collé à l'équipement vibrant (6', figure 1). Les vibrations provoquent une oscillation du système entre les deux positions stables, donc la génération d'électricité.

Un avantage des modes de réalisation décrits est qu'ils permettent de ne pas intervenir sur le cadre boîtier 2 afin de flamber le système à lames. Cela facilite les montages des récupérateurs d'énergie sur les équipements produisant des vibrations.

Un autre avantage est qu'en mettant en flambage l'ensemble de lames 3 par une contrainte en son centre, on conserve la symétrie du système, ce qui favorise un fonctionnement oscillant entre les deux positions stables.

Bien que l'on ait exposé une réalisation préférée à deux dispositifs de conversion de part et d'autre de l'ensemble de lames, ce qui préserve la symétrie du dispositif, on peut prévoir un seul dispositif 5 à une extrémité de l'ensemble de lames, l'autre extrémité étant reliée directement au cadre 2.

Selon une autre variante, on prévoit deux dispositifs ou plus entre une extrémité de l'ensemble de lames 3 et le cadre 2.

On a fait référence à un cadre 2 car, dans la plupart des applications, ce cadre participe à la définition d'un boîtier pouvant être refermé avec deux plaques de part et d'autre du cadre. Toutefois, d'un point de vue fonctionnel, ce qui importe est que les deux côtés (les deux petits côtés 22 et 24 dans l'exemple représenté) ou points 225 et 245 entre lesquels s'étend la structure de lames 3 ne soient pas déformés pour mettre l'ensemble de lames en flambage. Ainsi, ces points 225 et 245 sont fixes.

A titre d'exemple, les bras de lame peuvent être formés à partir d'un ruban d'acier de largeur de l'ordre de 5 à 50 mm, par exemple de l'ordre de 20 mm, et d'épaisseur de l'ordre de 100 à 500 µm, par exemple de l'ordre de 200 µm. L'ensemble de lames 3 peut avoir, entre les deux dispositifs de conversion 5, une longueur de 5 à 20 cm, par exemple de l'ordre de 10 cm. Les masses 41 et 43 peuvent avoir chacune un poids de l'ordre de 10 à 250 g, par exemple de l'ordre de 50 g. Les masses 41 et 43 peuvent être fixées aux bras 352 et 354 (ou 353 et 355) par collage, soudure, vissage, ou tout autre moyen adapté. Bien entendu, les dimensions ci-dessus ne sont données qu'à titre d'exemple. En pratique, les dimensions du système peuvent être comprises entre quelques dixièmes de mm et quelques dizaines de cm.

Divers modes de réalisation et variantes ont été décrits. Ces divers modes de réalisation et variantes sont combinables et d'autres variantes apparaitront à l'homme de l'art. En particulier, d'autres géométries de cadre 2 pourront être prévues. De plus, si en principe, la structure sera mise en flambage en fin d'assemblage une fois pour toute, on peut prévoir une mise en flambage réversible permettant d'écarter les masses (par exemple par dévissage), soit pour mettre le récupérateur au repos, soit lors d'opérations de maintenance. Enfin, la mise en oeuvre pratique des modes de réalisation et variantes décrits est à la portée de l'homme du métier à partir des indications fonctionnelles données ci-dessus, en particulier pour ce qui est de dimensions à donner aux différents éléments en fonction de l'application.

## Revendications

1. Dispositif (1) de récupération d'énergie mécanique vibratoire comportant un ensemble (3) de lames ressort entre deux points (225, 245) fixes, et au moins deux masses (41, 43) respectivement de part et d'autre de l'ensemble de lames, dans lequel l'ensemble de lames est mis en flambage entre les deux points par rapprochement des masses l'une vers l'autre, l'ensemble de lames ayant, une fois mis en flambage, exactement deux positions stables.

2. Dispositif selon la revendication 1, dans lequel, en l'absence d'action mécanique extérieure, les deux positions stables de l'ensemble de lames (3) sont symétriques par rapport à une droite reliant les deux points fixes (224, 245).

3. Dispositif selon la revendication 1 ou 2, dans lequel lesdites masses (41, 43) sont distinctes de lames dudit ensemble de lames (3).

4. Dispositif selon l'une quelconque des revendications 1 à 3, dans lequel l'écart entre les deux masses (41, 43) est, une fois l'ensemble de lames (3) mis en flambage, maintenu constant indépendamment de l'énergie mécanique vibratoire appliquée au dispositif.

5. Dispositif selon l'une quelconque des revendications 1 à 4, dans lequel lesdites deux positions sont stables en l'absence de sollicitation extérieure.

6. Dispositif selon l'une quelconque des revendications 1 à 5, dans lequel la récupération d'énergie est due au passage de l'ensemble de lames (3), sous l'effet de l'énergie mécanique vibratoire, d'une desdites deux positions à l'autre.

7. Dispositif selon l'une quelconque des revendications 1 à 6, dans lequel l'ensemble de lames (3) comporte une portion centrale (35) entre deux bras d'extrémité (31, 33), la portion centrale (35) comportant deux bras centraux (352, 354 ; 353, 355) respectivement associés aux deux masses (41, 43).

8. Dispositif selon la revendication 7, dans lequel chaque bras central (352, 354 ; 353, 355) est fixé, en son milieu, à la masse (41, 43) à laquelle il est associé.

9. Dispositif selon la revendication 7 ou 8, dans lequel chaque masse (41, 43) comporte une plaque (412, 434) dont un bord est fixé, par une partie (414, 434) en saillie, à un des bras centraux (352, 354 ; 353, 355).

10. Dispositif selon l'une quelconque des revendications 1 à 9, comportant au moins un dispositif de conversion mécano-électrique (5) entre une extrémité de l'ensemble de lames (3) et l'un desdits points (225, 245).

11. Dispositif selon l'une quelconque des revendications 1 à 10, comportant au moins un dispositif de conversion mécano-électrique (5) à chaque extrémité de l'ensemble de lames (3).

12. Dispositif selon la revendication 10 ou 11, dans lequel chaque dispositif de conversion (5) comporte un élément piézoélectrique (52) dans une direction approximativement perpendiculaire à la direction de l'ensemble de lames (3).

13. Dispositif selon la revendication 12, dans lequel chaque dispositif de conversion (5) comporte une armature en forme de double arceau (54, 56), les milieux (545, 565) des arceaux étant reliés respectivement à une extrémité de l'ensemble de lames (3) et à l'un des points (225, 245).

14. Dispositif selon l'une quelconque des revendications 1 à 13, dans lequel lesdits points (225, 245) font partie de deux bords opposés (22, 24) d'un cadre (2) à l'intérieur duquel sont logés l'ensemble de lames (3) et les masses (41, 43).

15. Système de production d'électricité comportant :
- un équipement (5') soumis à des vibrations mécaniques ; et
- un dispositif (1) selon l'une quelconque des revendications 1 à 14.

16. Système selon la revendication 15, dans lequel le dispositif (1) est fixé à l'équipement (5').

## Patentansprüche

1. Vorrichtung (1) zur Rückgewinnung mechanischer Vibrationsenergie, umfassend eine Anordnung (3) von Federblättern zwischen zwei festen Punkten (225, 245) und mindestens zwei Massen (41, 43) jeweils beiderseits der Federblattanordnung, wobei die Federblattanordnung zwischen den zwei Punkten durch Annäherung der Massen zueinander zum Knicken gebracht wird, wobei die Federblattanordnung, sobald sie zum Knicken gebracht wird, genau zwei stabile Positionen aufweist.

2. Vorrichtung nach Anspruch 1, wobei die zwei stabilen Positionen der Federblattanordnung (3) in Abwesenheit einer äußeren mechanischen Einwirkung symmetrisch zu einer Geraden sind, die die zwei festen Punkte (224, 245) verbindet.

3. Vorrichtung nach Anspruch 1 oder 2, wobei die Massen (41, 43) von den Federblättern der Federblattanordnung (3) getrennt sind.

4. Vorrichtung nach einem der Ansprüche 1 bis 3, wobei der Abstand zwischen den zwei Massen (41, 43), sobald die Federblattanordnung (3) zum Knicken gebracht wird, unabhängig von der an der Vorrichtung anliegenden mechanischen Vibrationsenergie konstant gehalten wird.

5. Vorrichtung nach einem der Ansprüche 1 bis 4, wobei die zwei Positionen in Abwesenheit einer äußeren Belastung stabil sind.

6. Vorrichtung nach einem der Ansprüche 1 bis 5, wobei die Energierückgewinnung auf den Übergang der Federblattanordnung (3), unter der Einwirkung der mechanischen Vibrationsenergie, von einer der zwei Positionen in die andere zurückzuführen ist.

7. Vorrichtung nach einem der Ansprüche 1 bis 6, wobei die Federblattanordnung (3) einen mittleren Abschnitt (35) zwischen zwei Endarmen (31, 33) aufweist, wobei der mittlere Abschnitt (35) zwei Mittelarme (352, 354; 353, 355) aufweist, die jeweils den zwei Massen (41, 43) zugeordnet sind.

8. Vorrichtung nach Anspruch 7, wobei jeder Mittelarm (352, 354; 353, 355) in seiner Mitte an der Masse (41, 43), welcher er zugeordnet ist, befestigt ist.

9. Vorrichtung nach Anspruch 7 oder 8, wobei jede Masse (41, 43) eine Platte (412, 434) aufweist, deren eine Kante durch einen vorspringenden Abschnitt (414, 434) an einem der Mittelarme (352, 354; 353, 355) befestigt ist.

10. Vorrichtung nach einem der Ansprüche 1 bis 9, umfassend mindestens eine mechanisch-elektrische Umwandlungsvorrichtung (5) zwischen einem Ende der Federblattanordnung (3) und einem der Punkte (225, 245).

11. Vorrichtung nach einem der Ansprüche 1 bis 10, umfassend mindestens eine mechanisch-elektrischen Umwandlungsvorrichtung (5) an jedem Ende der Federblattanordnung (3).

12. Vorrichtung nach Anspruch 10 oder 11, wobei jede Umwandlungsvorrichtung (5) in einer Richtung ungefähr senkrecht zur Richtung der Federblattanordnung (3) ein piezoelektrisches Element (52) aufweist.

13. Vorrichtung nach Anspruch 12, wobei jede Umwandlungsvorrichtung (5) eine Armatur in Form eines Doppelbügels (54, 56) aufweist, wobei die Mitten (545, 565) der Bügel jeweils mit einem Ende der Federblattanordnung (3) und einem der Punkte (225, 245) verbunden sind.

14. Vorrichtung nach einem der Ansprüche 1 bis 13, wobei die Punkte (225, 245) Teil zweier gegenüberliegender Kanten (22, 24) eines Rahmens (2) sind, in welchem die Federblattanordnung (3) und die Massen (41, 43) untergebracht sind.

15. Stromerzeugungssystem, umfassend:
- eine Ausrüstung (5'), die mechanischen Vibrationen ausgesetzt ist; und
- eine Vorrichtung (1) nach einem der Ansprüche 1 bis 14.

16. System nach Anspruch 15, wobei die Vorrichtung (1) an der Ausrüstung (5') befestigt ist.

## Claims

1. Device (1) for harvesting mechanical vibration energy, comprising an assembly (3) of blades sprung between two fixed points (225, 245), and at least two masses (41, 43) respectively on either side of the assembly of blades, in which the assembly of blades is buckled between the two points by bringing the masses towards each other, the assembly of blades having, once buckled, exactly two stable positions.

2. The device according to claim 1, wherein, in the absence of external mechanical action, the two stable positions of the assembly of blades (3) are symmetrical with respect to a line connecting the two fixed points (224, 245).

3. The device according to claim 1 or 2, wherein said masses (41, 43) are distinct from blades of said assembly of blades (3).

4. The device according to any one of claims 1 to 3, wherein the interval between the two masses (41, 43) is, once the assembly of blades (3) has been buckled, maintained constant independently from the mechanical vibration energy applied to the device.

5. The device according to any one of claims 1 to 4, wherein said two positions are stable in the absence of external stress.

6. The device according to any one of claims 1 to 5, wherein the energy harvesting is due to the passage of the assembly of blades (3), under the effect of the mechanical vibration energy, from one of said two positions to the other.

7. The device according to any one of claims 1 to 6, wherein the assembly of blades (3) comprises a central portion (35) between two end arms (31, 33), the central portion (35) comprising two central arms (352, 354; 353, 355) respectively associated with the two masses (41, 43).

8. The device according to claim 7, wherein each central arm (352, 354; 353, 355) is attached, in its middle, to the mass (41, 43) with which it is associated.

9. The device according to claim 7 or 8, wherein each mass (41, 43) includes a plate (412, 434), one edge of which is attached, by a projecting portion (414, 434), to one of the central arms (352, 354; 353, 355).

10. The device according to any one of claims 1 to 9, comprising at least one mechano-electrical conversion device (5) between one end of the assembly of blades (3) and one of said points (225, 245).

11. The device according to any one of claims 1 to 10, comprising at least one mechano-electric conversion device (5) at each end of the assembly of blades (3).

12. The device according to claim 10 or 11, wherein each conversion device (5) comprises a piezoelectric element (52) in a direction approximately perpendicular to the direction of the assembly of blades (3).

13. The device according to claim 12, wherein each conversion device (5) comprises a frame in the form of a double arch (54, 56), the middles (545, 565) of the arches being respectively connected to one end of the assembly of blades (3) and to one of the points (225, 245).

14. The device according to any one of claims 1 to 13, wherein said points (225, 245) are part of two opposite edges (22, 24) of a frame (2) inside which the assembly of blades (3) and the masses (41, 43) are housed.

15. Electric generator system comprising :
- an equipment (5') subjected to mechanical vibrations; and
- a device (1) according to any of claims 1 to 14.

16. The system according to claim 15, wherein the device (1) is attached to the equipment (5').
